# EUROPEAN PATENT SPECIFICATION

(11) **EP 3 136 419 B1**
(45) Date of publication and mention of the grant of the patent: **18.04.2018**
(21) Application number: 15306338.3
(22) Date of filing: 31.08.2015
(51) Int. Cl.: H01J 37/32, H01L 31/18, C23C 14/04, C23C 16/509

(54) **PLASMA GENERATING APPARATUS AND METHOD OF MANUFACTURING PATTERNED DEVICES USING SPATIALLY RESOLVED PLASMA PROCESSING**
PLASMAERZEUGUNGSVORRICHTUNG UND VERFAHREN ZUR HERSTELLUNG VON STRUKTURIERTEN VORRICHTUNGEN MITTELS RÄUMLICH AUFGELÖSTER PLASMAVERARBEITUNG
APPAREIL DE GÉNÉRATION DE PLASMA ET PROCÉDÉ DE FABRICATION DE DISPOSITIFS À MOTIFS À L'AIDE D'UN TRAITEMENT PLASMA À RÉSOLUTION SPATIALE

(43) Date of publication of application: 01.03.2017
(73) Proprietor: Total S.A., 92400 Courbevoie (FR); École Polytechnique, 91120 Palaiseau (FR); Centre National de la Recherche Scientifique, 75016 Paris (FR)
(72) Inventor: JOHNSON, Erik, 75020 PARIS (FR); BRUNEAU, Bastien, 75014 PARIS (FR); ROCA I CABARROCAS, Pere, 91140 VILLEBON SUR YVETTE (FR); BULKIN, Pavel, 91140 VILLEBON SUR YVETTE (FR)
(74) Representative: Jacobacci Coralis Harle

(56) References cited:
- WO-A1-2010/021539
- JP-A- H08 306 499
- US-A1- 2012 156 592
- US-A1- 2013 105 303
- T. HUISKAMP ET AL: "Maskless Patterning by Pulsed-Power Plasma Printing", IEEE TRANSACTIONS ON PLASMA SCIENCE., vol. 40, no. 7, 1 July 2012 (2012-07-01), pages 1913-1925, XP055246781, US ISSN: 0093-3813, DOI: 10.1109/TPS.2012.2195510
- MICHAEL THOMAS ET AL: "Plasma Printing and Related Techniques - Patterning of Surfaces Using Microplasmas at Atmospheric Pressure", PLASMA PROCESSES AND POLYMERS, vol. 9, no. 11-12, 3 September 2012 (2012-09-03), pages 1086-1103, XP055247020, DE ISSN: 1612-8850, DOI: 10.1002/ppap.201200020

## Description

### TECHNICAL FIELD OF THE INVENTION

The invention relates to an apparatus and a method for generating and handling plasma used for deposition and/or etching of materials.

More precisely the invention relates to an apparatus and a method for producing devices incorporating patterned thin film produced by plasma deposition and/or plasma etching at a moderate cost compared to conventional masking, photolithography, or laser processing steps.

The invention also relates to the manufacturing of high efficiency solar cells at reduced manufacturing costs. The invention concerns in particular the manufacturing of interdigitated back contact (IBC) solar cells.

### BACKGROUND INFORMATION AND PRIOR ART

Numerous documents describe devices and methods for the manufacture of devices incorporating patterned thin film and in particular solar cell devices.

The steps of thin film deposition and/or etching can be realized by different techniques and in particular by plasma enhanced chemical vapour deposition (PECVD) in general at low temperatures (less than 300 °C).

In microelectronics, the patterning step is generally based on photolithography to generate patterned thin films with sub-micrometric critical dimensions (CD) and with very high aspect ratios. However, photolithography requires additional materials, processing steps and expensive tools, such as a stepper, and thus induces large manufacturing costs. Much lower resolution techniques may be used, but these also involve multiple masking and etching steps.

Laser ablation can also be used for forming holes in a thin film stack without involving masking. However, laser processing is also expensive.

High efficiency industrial crystalline silicon (c-Si) solar cells use localized contacts to reduce the surface area in contact with metal or to reduce shading by metallic gridlines.

The highest efficiency industrial c-Si cells use an interdigitated back contact (IBC) configuration, but this is an expensive design to implement, involving more process steps: laser ablation for forming dielectric openings for point contacts or lithography for forming the IBC contacts. Nevertheless, IBC designs and point contacts are currently used in industry, as described by R. Swanson et al. (Proceeding of the 33rd IEEE PVSC, San Diego, CA, USA, 2008).

Another industrial high-efficiency design (HIT technology) uses a thin intrinsic amorphous hydrogenated silicon (a-Si:H) layer, deposited by PECVD, as the passivating layer. HIT passivation is advantageously realized at low temperature (less than about 250 °C) thus reducing the thermal budget of the process, and resulting in very good passivation properties for the wafer surface.

Panasonic (Masuko et al, IEEE Journal of Photovoltaics 4 (2014) 1433-1435) has recently demonstrated an IBC solar cell design using large area HIT passivation. However, using a thin intrinsic a-Si:H passivation layer in an IBC configuration involves a subsequent patterning step for the doped layers, using photolithography, thus reducing the cost effectiveness of the low temperature HIT passivation.

One of the challenges in implementing a masking operation on the pristine surface of a silicon wafer (with oxide removed) is the high sensitivity of this surface to damage and contamination. Document WO-A1-2010/021539 discloses a device for generating a plasma discharge, suitable for maskless direct patterning of a substrate.

### SUMMARY OF THE INVENTION

Therefore one object of the invention is to provide an apparatus and a method for forming devices having a patterned structure, such as a patterned surface or patterned layers, especially for high-efficiency solar cell applications or semiconducting devices or optoelectronic devices, at a reduced manufacturing cost and preferably at low temperature.

A further object of the invention is to provide an alternative apparatus and method for forming interdigitated contacts in IBC solar cells and/or for forming dielectric openings for point contacts in solar cells.

A further object of the invention is to provide a fully integrated method and apparatus enabling both surface passivation and patterning in a single processing flow step and/or in a single processing tool chamber, so as to prevent surface damage, contamination, and avoiding additional tool-related capital cost.

The above objects are achieved according to the invention by providing a plasma generating apparatus for manufacturing devices having a patterned layer or surface, as defined in claim 1. The plasma generating apparatus comprises a plasma reactor chamber, a gas feed assembly for introducing an input gas into the plasma reactor chamber at a chosen pressure, a first electrode assembly and a second electrode assembly placed in the plasma reactor chamber, the first electrode assembly being spaced apart from the second electrode assembly by an inter-electrode volume and an electrical power supply for generating a time-varying or a constant voltage difference V(t) between the first electrode assembly and the second electrode assembly.

According to the invention, the first electrode assembly comprises a plurality of protrusions and a plurality of recesses, the second electrode assembly being configured for receiving a substrate having a surface facing the plurality of protrusions and the plurality of recesses, the protrusions and recesses being dimensioned and set at respective distances from the surface of the substrate so as to generate a plurality of spatially isolated plasma zones located selectively either between said surface of the substrate and said plurality of recesses or between said surface of the substrate and said plurality of protrusions at the chosen pressure of the input gas.

The plasma generating apparatus thus enables to perform plasma processing on the surface of the substrate on areas defining a pattern which is roughly delimited by the protrusions and recesses, so as to form a pattern on the surface of the substrate.

The invention enables spatially selective deposition of patterned layer(s) using plasma enhanced chemical vapour deposition, without touching the substrate surface. Depending on the plasma conditions, and in particular on the chemical composition of the input gas, the invention also enables spatially selective etching of the surface of the substrate, thus forming a patterned surface with openings, using plasma enhanced chemical vapour etching without touching the substrate surface. In other words the invention achieves a masking operation without applying a mask on the surface of the substrate.

The present disclosure is based on shaping the powered first electrode assembly, thus using geometrical dimensions of the first electrode assembly as well as shadowing effects to limit laterally the ignition of the plasma to well-defined volumes. This allows a rough masking operation to be implemented. Furthermore, multiple patterns can be implemented by changing the electrode configuration in real time. Furthermore, a uniform, maskless deposition, or etching process can be done in the same plasma reactor chamber by backing the electrode away from the surface of the substrate, so that the plasma ignition is not limited laterally by the protrusions and recesses but extends over the interelectrode volume.

According to a particular regime of operation, for a given optimal applied voltage difference V(t), which may be a constant DC potential or a time varying voltage difference ideally with frequency components in the radio-frequency range (500 kHz to 100 MHz), the recesses are dimensioned to be placed at a second distance from the surface of the substrate such that, for the applied voltage difference V(t), a product of the chosen pressure and the second distance is comprised between a first plasma ignition threshold and a second plasma extinction threshold (thus ensuring local plasma ignition between the recesses and the surface of the substrate), and the protrusions are dimensioned to be placed at a first distance from the surface of the substrate such that, for the applied voltage difference V(t), another product of the chosen pressure and the first distance is lower than the first plasma ignition threshold (thus ensuring no plasma ignition between the protrusions and the surface of the substrate), such that the plasma generating apparatus generates spatially isolated plasma zones between the surface of the substrate and the recesses without generating plasma locally between the surface of the substrate and the protrusions.

According to a particular aspect of the invention, for a given optimal applied voltage difference V(t), which may be a constant DC potential or a time varying one ideally with frequency components in the radio-frequency range (500 kHz to 100 MHz), the protrusions are dimensioned to be placed at a first distance from the surface of the substrate such that, for the applied voltage difference V(t), the product of the pressure and the first distance is comprised between a first plasma ignition threshold and a second plasma extinction threshold (thus ensuring local plasma ignition between the protrusions and the surface of the substrate), and the recesses are dimensioned to be placed at a second distance from the surface of the substrate such that, for the applied voltage difference V(t), another product of the chosen pressure and the second distance is larger than a second plasma extinction threshold (ensuring no plasma ignition locally between the recesses and the surface of the substrate), such that the plasma generating apparatus generates spatially isolated plasma zones between the surface of the substrate and the protrusions without generating plasma locally between the surface of the substrate and the recesses.

According to still another regime of operation, the first electrode assembly comprises a plurality of protrusions of rectangular profile placed at a first distance from the surface of the substrate and a plurality of recesses of rectangular profile having bottoms at a second distance from the surface of the substrate.

According to a particular embodiment of the invention, the first electrode assembly comprises at least a first and a second part, the first part being mobile relatively to the second part between a first position and a second position, such that, in the first position said first electrode assembly forms a plurality of protrusions and a plurality of recesses, and, in the second position, the first electrode assembly forms a flat surface facing the surface of the substrate.

According to another embodiment of the invention, the plurality of recesses comprises a plurality of cavities, each cavity being connected to the inter-electrode volume by a channel, the cavities being dimensioned such that the apparatus generates plasma within said cavities at the chosen pressure, and the channels being dimensioned such that the plasma generated in the cavities diffuses toward the inter-electrode volume.

According to a particular aspect of this embodiment, the plurality of recesses or a subset of the plurality of recesses is connected to a common cavity, the common cavity being connected to at least one gas inlet and to at least one gas outlet, so as to ensure optimal gas flow conditions.

According to particular aspects of this embodiment, said cavity has a square, rectangular, spherical or conic profile and/or the channels have a cross-section shape chosen among a rectangular, trapezoidal, conical or cylindrical shape, or a shape chosen to generate a pattern with determined spatial profile on the surface of the substrate. Optionally, the channels being interconnected to a common cavity, the channels of the interconnected channels have respective gas inlets and/or gas outlets with determined shapes so as to form patterned features with determined profile shape.

According to a particular embodiment, the first electrode assembly comprises at least a first and a second sub-sets of recesses, the first sub-set of recesses being electrically isolated from the second sub-set of recesses, and the first electrode assembly comprises a first and a second sub-electrodes, the first, respectively second, sub-electrode electrically connecting the first, respectively second, sub-set of recesses, and the electrical power supply is configured for generating a first, respectively a second, voltage difference between the first, respectively second, sub-electrodes and the second electrode assembly.

According to a particular aspect, the first electrode assembly comprises at least a first and a second sub-sets of recesses, and the gas feed assembly comprises a first and a second input gas lines, the first, respectively second, gas line being in fluidic communication with the first, respectively second, sub-set of recesses, so as to inject a first, respectively second, input gas into the first, respectively second, sub-set of recesses.

According to a particular and advantageous aspect of the invention, the plurality of protrusions and the plurality of recesses are arranged in a one-dimension or two-dimension periodic array.

According to another particular and advantageous aspect of the invention, the first electrode assembly and/or the second electrode assembly is/are mounted on a translation or rotating stage.

According to another embodiment of the invention, the plasma generating apparatus comprises an electric source configured for generating a voltage difference to be applied between the first and second electrode, wherein the voltage difference is constant over time, or comprises a single base frequency in the range between 500kHz and 100MHz or comprises a plurality of harmonics of a base frequency in the range between 500kHz and 100MHz, and wherein the respective amplitudes and phases of the plurality of harmonics are selected so as to generate voltage difference having waveform with an amplitude asymmetry (for example resembling a series of peaks or valleys) or with a slope asymmetry (for example resembling a sawtooth voltage waveform).

The invention also concerns a method of manufacturing patterned devices using spatially resolved plasma processing, as defined in claim 13, comprising the steps of:
- Placing a substrate in a plasma reactor chamber of a plasma generating apparatus, the substrate being in contact with a second electrode assembly and having a surface facing a first electrode assembly comprising a plurality of protrusions and a plurality of recesses;
- Injecting an input gas or gas mixture into the plasma reactor chamber under a chosen pressure ;
- Configuring the first electrode assembly such that the protrusions are at a first distance and the recesses are at a second distance from the surface of the substrate,
- Applying a DC or radio-frequency voltage difference between the first electrode assembly and the second electrode assembly, the protrusions and recesses being dimensioned and set at respective distances from the surface of the substrate so as to generate a plurality of spatially isolated plasma zones located selectively either between the surface of the substrate and the plurality of recesses or between the surface of the substrate and the plurality of protrusions at the chosen pressure of the input gas, so as to form by deposition or etching a pattern on the surface of the substrate.

According to a particular and advantageous aspect, the method of manufacturing patterned devices further comprises a step of moving the first electrode assembly relatively to the second electrode assembly so as to modify the first distance, and/or respectively the second distance, such that the product of the chosen pressure and the first distance, and respectively the product of the chosen pressure and the second distance, are both comprised between a first plasma ignition threshold and a second plasma extinction threshold, so as to generate a spatially uniform plasma zone extending over the inter-electrode volume.

According to another particular and advantageous aspect, the method of manufacturing patterned devices further comprises the steps of:
- electrically isolating a first sub-set of recesses from a second sub-set of recesses of the first electrode assembly ; and
- applying a first, respectively, second, voltage difference between the second electrode assembly and the first respectively, second, sub-set of recesses.

According to another particular and advantageous aspect, the method of manufacturing patterned devices further comprises the steps of:
- Fluidically connecting a first, respectively second, gas line to a first, respectively second, sub-set of recesses of the first electrode assembly ; and
- Injecting a first, respectively second, input gas into the first, respectively second, sub-set of recesses, and/or
- Providing a first, respectively second, gas flow outlet connected the first, respectively second, sub-set of recesses, to prevent mixing of gas composition and achieve different deposition/etching processes under the first and second sub-set of recesses.

The invention applies in particular to the manufacture of photovoltaic solar cell devices in a plasma generating apparatus and/or using a method of manufacturing patterned devices as disclosed herein.

### BRIEF DESCRIPTION OF THE DRAWINGS

This description is given for non limiting illustrative purposes only and will be better understood when referring to the annexed drawings wherein:
- Figure 1 represents schematically a cross-section of a plasma processing apparatus according to a first embodiment, in a first operating regime;
- Figure 2 represents schematically a cross-section of the first embodiment of a plasma processing apparatus, in another operating regime;
- Figure 3 represents schematically a breakdown voltage curve for a plasma processing apparatus as a function of the product of input gas pressure by electrode separation, commonly referred to as the Paschen curve;
- Figures 4A-4B represent schematically a cross-section of a variant of the first embodiment of a plasma processing apparatus, with a two-part electrode;
- Figures 5A-5C represent schematically an example of different steps for the manufacture of patterned devices using spatially resolved plasma according to an embodiment of the invention;
- Figure 6 illustrates schematically Interdigitated electrodes obtained from the exemplary process of Figure 5;
- Figures 7A-7B illustrate examples of forming point contacts using spatially resolved plasma processing according to various embodiments of the invention;
- Figure 8 represents schematically a cross-section of a second embodiment of a plasma processing apparatus;
- Figure 9 represents schematically a cross-section of a variant of electrode design according to the second embodiment of a plasma processing apparatus;
- Figure 10 represents schematically cross-section of various cavities according to the second embodiment of a plasma processing apparatus;
- Figure 11 represents schematically in cross-section still another variant of configuration of gas injection wherein the channels are connected to a common cavity ;
- Figure 12 represents schematically in cross-section another variant of electrode configuration according to an embodiment of the invention;
- Figure 13 represents schematically in cross-section still another variant of configuration of gas injection according to another embodiment of the invention;
- Figure 14 represents schematically in cross-section still another variant of applied voltage difference of various waveforms configured for adjusting the proximity of the plasma area relatively to the surface of the sample.

### DETAILED DESCRIPTION OF EXAMPLE(S)

The present disclosure concerns a technique to perform contactless masking of a plasma process, such as PECVD deposition or etching, by restricting spatially, and more precisely laterally, the area of plasma ignition.

In an embodiment this is achieved through a powered electrode design for a radio-frequency-PECVD system, operating in a first regime, generally at low pressure (<10 Torr (<1333 Pa)), wherein the ignition of the plasma close to the protrusion of the first electrode assembly is inhibited by the first electrode assembly-substrate distance being less than the sheath width of the plasma used for deposition.

In various embodiments, channels or holes in the electrode determine where the plasma lights in the first operating regime, where a small distance prevents plasma ignition at low pressure.

In another operating regime, generally at high pressure (>10 Torr (>1333 Pa)), the ignition of the plasma of the first electrode assembly is enabled close to the protrusion and inhibited close to the recesses by the first electrode assembly-substrate distance being too large for sustaining a plasma in the recesses, under the chosen pressure and voltage conditions used for the plasma.

The spatially selective ignition of the plasma allows one to deposit or etch thin-films in predetermined areas without contacting the surface, thus achieving contactless masking. The critical dimensions and feature sizes of the patterned layers obtained by this technique are in the sub-millimeter range (from one to several hundreds of micrometers) and are consistent with those required for the fabrication of interdigitated back contacts (IBC) solar cells or point contact openings for solar cells.

### Device

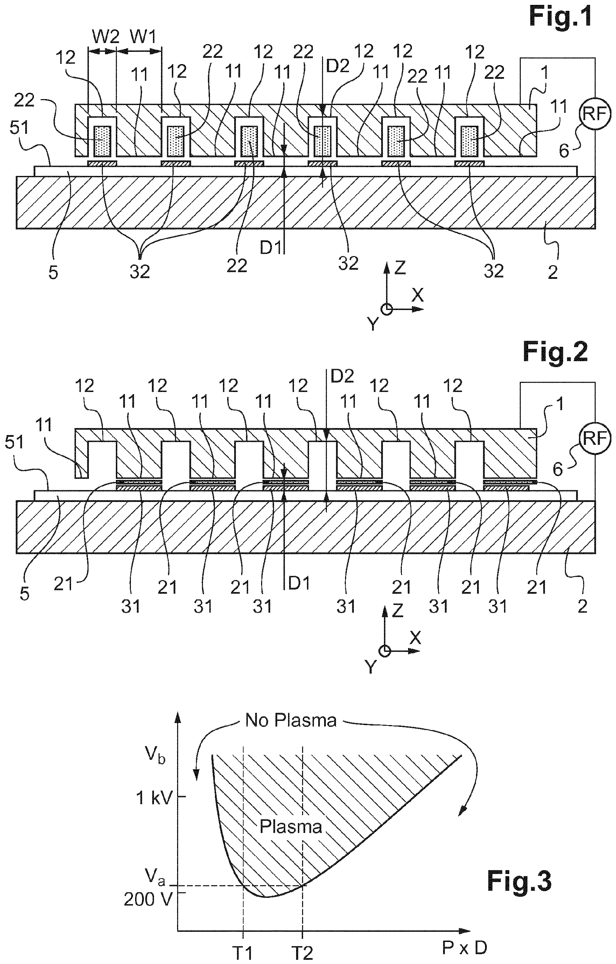

Figure 1 represents schematically a cross-section of a plasma processing apparatus according to a first embodiment of the invention, and operating in a first regime. Generally, the plasma processing apparatus comprises a vacuum chamber in fluidic connection with a pressured gas line for injecting an input gas and a vacuum pumping system for evacuating output gas. The vacuum chamber encloses a substrate holder and an electrode system for powering the plasma inside the reaction chamber.

More specifically, we consider the representative case of a radio-frequency (RF) capacitively coupled plasma reactor comprising a first electrode assembly 1 and a second electrode assembly 2. An RF power supply 6 is electrically connected to the first and second electrode assemblies 1, 2, so as to apply an RF voltage difference between the first and second electrode assemblies. In this example, the second electrode assembly 2 is electrically connected to ground, so that the first electrode assembly 1 is the powered electrode.

A substrate 5 is placed on the second electrode assembly 2 so that a surface 51 of the substrate 5 faces the first electrode assembly 1. The substrate is for example a semiconductor such as monocrystalline or polycrystalline silicon or a glass substrate. Alternatively, the substrate 5 may comprise a thin film stack forming the surface 51. The surface 51 of the substrate 5 may be flat or may be a patterned surface.

In the example of figure 1, the second electrode assembly 2 is flat, as in a conventional capacitively coupled plasma reactor. In contrast, in this first embodiment, the first electrode assembly 1 comprises a plurality of recesses 12 separated from each other or surrounded by protrusions 11. In the example of Figure 1, the protrusions 11 and the recesses 12 have a rectangular shape, having a width W1, respectively W2 along an axis X parallel to the surface of the substrate. The protrusions 11 are at a first distance D1 from the surface 51 of the substrate, and the recesses 12 are at a second distance D2 from the surface 51 of the substrate. The gas injection system (not represented on Figure 1) is configured so that the input gas fills the inter-electrode volume between the first and second electrode assemblies and thus fills the recesses 12.

More precisely, in a first regime illustrated in Figure 1, the first distance D1 is adjusted so that, at the applied voltage and at the chosen pressure P of the input gas in the plasma reactor chamber, the first distance D1 is lower than a first threshold value corresponding to a plasma ignition threshold. This first regime is generally operated at low pressure (<10 Torr (<1333 Pa)). As an example of first regime operating conditions, the input gas is a mixture of at minima a deposition precursor gas (such as SiH₄) or an etching gas (such as SF₆) and possibly a second buffer gas (such as H₂) at a pressure between 0.1 and 10 Torr (between 13 and 1333 Pa), the width W1 is between 0.75 mm and 2 mm, the first distance D1 is set to between 0.1 and 1.0 mm, so that this first distance D1 is too small for plasma ignition between the protrusions 11 and the surface 51 of the sample 5 for the chosen applied RF voltage, with an amplitude between 200V and 800V.

However, in this first regime, the recesses 12 are dimensioned so that the second distance D2 is above the first threshold value corresponding to a plasma ignition threshold. Thus, several localized plasmas 22 ignite within the recesses 12 and extend in front of the recesses 12 up to the surface 51 of the substrate 5. However, the protrusions 11 provide a quenching effect preventing the localized plasma zones 22 to merge into an extended plasma. Thus, the localized plasma areas 22 remain confined into spatially isolated spaces between the recesses 12 and the surface 51 of the substrate 5. As an example of first regime, the width W2 of the recesses 12 is between 0.1 mm and 5 mm, the second distance D2 is set to at least 2 mm, the width W1 of the protrusions 11 being at least of 0.1 mm.

This first regime enables for example local deposition of a patterned layer 32 by PECVD, the lateral dimension of the patterned thin layer 32 along the axis X being determined mainly by the widths W1 of the protrusions 11 and by the widths W2 of the recesses 12.

The recesses 12 may have a one-dimensional geometry and extend along the Y axis with a similar profile, for generating patterns extending longitudinally on the surface of the sample along the Y-axis.

Alternatively, the recesses 12 may have a two-dimension geometry and for example, have a similar profile as illustrated in Figure 1 along the Y axis, for generating patterns limited in both the X and Y directions on the surface 51 of the sample 5.

Of course, more complex geometries of protrusions 11 and recesses 12 are also contemplated without departing from the frame of the present disclosure.

The relative proportion of deposited areas patterned layer 32 versus non-deposited areas in the example of Figure 1 would be consistent with an application of leaving an area to deposit another layer in between the patterned layer 32 , for example, for the creation of interdigitated contacts.

By increasing the width W2 of the recesses 12 and relatively decreasing the width W1 of the protrusions 11, as well as establishing these recesses in two dimensions, enables one to deposit continuous films with small holes. If such films are formed from a dielectric material, such a configuration could be used to implement for example point contacts.

Figure 2 represents schematically a cross-section of the first embodiment of plasma processing apparatus operating in a second regime. The same reference numbers refer to the same elements as represented on figure 1. In this second regime, the first distance D1 is adjusted so that, for a given applied voltage difference and at a chosen pressure P of the input gas in the plasma reactor chamber, generally at relatively high pressure (>10 Torr (>1333 Pa)), the first distance D1 is higher than a first threshold value corresponding to a plasma ignition threshold. Thus, in the second regime, localized plasmas 21 ignite between the protrusions 11 and the surface 51 of the substrate 5. At the same time, the recesses 12 are located at a second distance D2 which is above a second threshold value corresponding to a plasma extinction threshold. The recesses 12 are dimensioned so that a quenching effect prevents the localized plasma zones 21 to extend into the recesses. Thus, the localized plasma areas 21 remain confined into spatially isolated spaces between the protrusions 11 and the surface 51 of the substrate 5.

As an example of the second regime, the input gas mixture is at minima composed of a deposition precursor gas (such as SiH₄) or an etching gas (such as SF₆), and possibly a buffer gas (such as He) at a pressure of between 10 to 100 Torr (between 1.3 x 10³ and 1.3 x 10⁴ Pa), the applied voltage is between 100V and 1 kV, the first distance D1 is set to between 0.1 and 1 mm, so that this first distance D1 is high enough for plasma ignition between the protrusions 11 and the surface 51 of the sample 5, and the second distance D2 is set to 2 to 10 mm so that the second distance D2 is too high for plasma ignition in the recesses 12.

In the second regime, where the pressure combined with a large distance limits ignition (usually high pressure), protrusions 11 from the surface of the electrode determine the pattern 31 that is deposited, resulting in a complementary or negative image of the positive pattern layer 32 deposited in the first regime, with a same first electrode assembly.

Figure 3 helps to explain the different operating regimes set forth in the invention. Figure 3 represents schematically a breakdown voltage curve Vb of a plasma processing apparatus as a function of the product of input gas pressure P and the electrode separation D for a capacitively coupled RF plasma reactor or a directly coupled DC plasma reactor, commonly called the Paschen curve. The breakdown voltage Vb is defined as the minimum voltage to be applied between electrodes for plasma ignition as a function of the pressure P, for a given interelectrode distance D or as a function of the interelectrode distance D, for a given pressure P.

For processing plasmas, the range of pressure P is generally comprised between a few milliTorrs and several tens of Torrs (between a few Pa and several thousands of Pa), or less than 100 Torr (less than 1.3 x 10⁴ Pa). We consider an RF voltage amplitude Va applied to the first electrode assembly 1, this RF voltage amplitude Va being higher than the minimum value of the breakdown voltage curve. The intersection of this applied voltage Va with the breakdown voltage curve defines a first threshold value T1 and a second threshold T2.

First, we consider the area of the graph where the product PxD of pressure P by the interelectrode distance D is below the first threshold value T1 : in these conditions, there is no plasma ignition. Or, in other words, for a chosen pressure P and chosen RF voltage amplitude Va, if the electrode separation D is below a first threshold distance, there is no plasma ignition since the applied voltage Va is lower than the breakdown voltage Vb curve. Next, we consider the area of the graph where the product PxD is above the first threshold value T1 and below the second threshold value T2 : in these conditions, there is plasma ignition because the voltage applied Va to the electrodes is higher than the breakdown voltage Vb curve. Or, in other words, for a chosen pressure P and a chosen applied voltage Va, if the electrode separation D is higher than the first threshold distance and below a second threshold distance, plasma ignition occurs. Finally, we consider the area of the graph where the product PxD is above the second threshold value T2 : in these conditions, there is no plasma since the applied voltage Va is lower than the breakdown voltage Vb curve. Or, in other words, for a chosen pressure P and a chosen applied voltage Va, if the electrode separation D is higher than the second threshold distance, there is no plasma ignition.

The first operating regime of the plasma generating apparatus according to the first embodiment of the invention, as illustrated in Figure 1, corresponds to the conditions where the first distance D1 is smaller than a first threshold distance T1/P as determined on Figure 3 for a given pressure P and applied voltage Va, and where the second distance D2 is between a first and a second threshold distances [T1/P; T2/P], for the same pressure P and applied voltage Va.

In contrast, the second operating regime of the plasma generating apparatus according to the first embodiment of the invention, as illustrated in Figure 2, corresponds to the conditions where the first distance D1 is between the first and the second threshold distances, and where the second distance D2 is larger than the second threshold distance, as determined in Figure 3. Or, for given distances D1 and D2, the pressure P is increased so that the product PxD1 is comprised between T1 and T2, and the product PxD2 is larger than T2.

Additionally, in a third regime, when both the first and second distances D1 and D2 are increased and/or when the pressure P is increased, so that both products PxD1 and PxD2 are situated between the first threshold T1 and the second threshold T2, the plasma ignites over the whole first electrode assembly, so that the plasma areas 22 within the recesses 12 merge with the plasma areas 21 facing the protrusions, thus forming a single extended plasma area.

Alternatively or complementarily to the change in distance between the first electrode assembly 1 and the surface of the substrate, those skilled in the art will recognize that the three different regimes described above can be obtained by controlling the input pressure P and/or the applied voltage Va. This technique, however, is limited by the process condition limits necessary to achieve the desired steps, in particular passivation of a surface or deposition of high-quality doped layers.

However, for the sake of clarity of the present disclosure, we make the assumption that the applied voltage Va and input gas pressure P are maintained constant, and that the distance between the first electrode assembly 1 and the surface of the substrate is controlled for operating in the appropriate regime.

It is to be observed that, until now, plasma processing apparatuses are generally operated in the conditions where a single plasma area forms between the first electrode assembly and the surface of the substrate, because processing uniformity is usually a strong requirement, either for deposition or for etching. Even in previous hollow cathode-type plasma generating systems, a single plasma area is formed below the plurality of hollows within the cathode, ensuring the uniform processing of a large area substrate. On the contrary, the present disclosure takes advantage of a plurality of laterally localized and isolated plasma areas 21, or 22, to perform localized plasma treatment on the surface 51 of the substrate 5, so as to enable spatially resolved thin film deposition or etching, and thus pattern deposition. By analogy with photolithography, this plasma processing technique may be called plasma-lithography as it enables one to deposit patterned thin films with determined critical dimensions (CD) and aspect ratios (AR).

A major advantage of the plasma-lithography technique is to enable direct deposition of a patterned thin film, without using a mask, thus avoiding the multiple processing steps associated with lithography, including photolithography, and avoiding any deleterious effects of the contact of a mask with the substrate surface.

Thus, plasma-lithography as disclosed herein enables drastic reduction in processing costs for the manufacture of patterned layers or devices.

In terms of performance, plasma-lithography enables one to form patterns with sub-millimeter critical dimensions, down to about a hundred micrometers along an axis X and/or Y. Such critical dimensions are well-suited for current requirements in industrial solar cell manufacturing.

The first electrode assembly can be formed from a single conductive part. For example, the recesses 12 are machined as holes or slits in a bulk metallic plate.

Alternatively, the first electrode assembly 1 comprises an assembly of parts attached to each other. In a variant alternative, the first electrode assembly 1 comprises several parts, at least one of the parts being mobile relatively to the other(s).

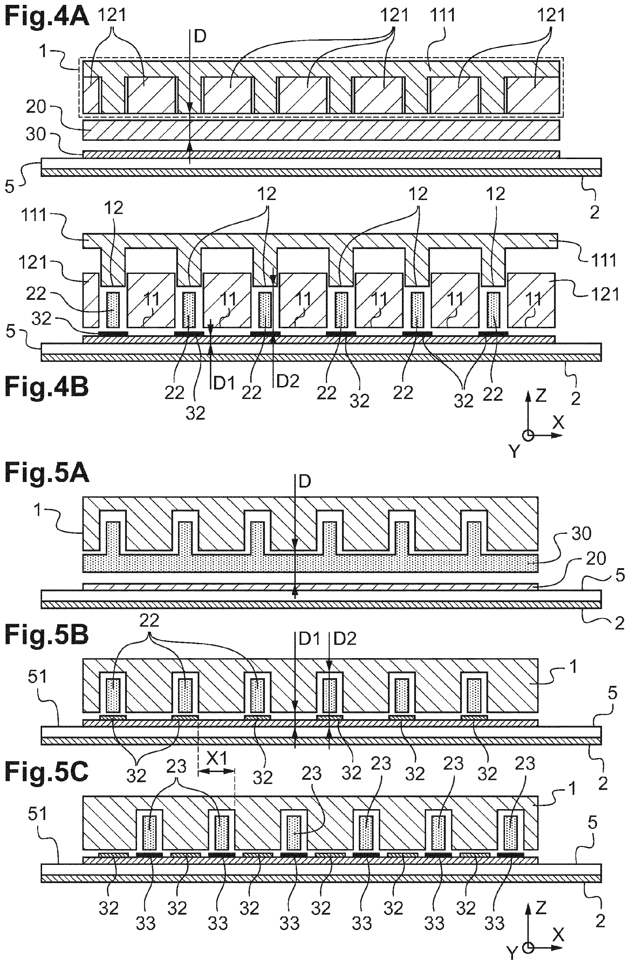

As an example Figure 4 represents schematically a cross-section of a variant of the first embodiment of a plasma processing apparatus, with the first electrode assembly 1 in two parts. More precisely, the first electrode assembly 1 comprises a first part 111 and a second part 121. Preferably, the first part 111 and second part 121 have complementary shapes, such as a comb for example. On figure 4A, the first part 111 and second part 121 are fitted so that the first electrode assembly 1 forms a flat surface at a distance D from the surface 51 of the substrate 5. The pressure P, distance D and applied voltage are adjusted so as to generate a plasma 20 between the first electrode assembly 1 and the surface 51 of the substrate 5. This first configuration enables for example deposition of a layer 30 having a uniform thickness (or non patterned) on the surface 51 of the substrate 5. For example, this configuration may be used for depositing a passivation layer of intrinsic amorphous hydrogenated silicon (i) a-Si:H. As an option, by changing the input gas, this first configuration of Fig. 4A may also be used for cleaning or removing an oxide layer from the surface 51 of the substrate 5 before deposition of the i-layer 30.

In a second position, illustrated Figure 4B, the second part 121 is translated along the Z axis in the direction of the sample surface 51 while the first part 111 remains fixed, so as to form recesses 12 and protrusions 11. In the example illustrated Fig. 4B, the second part is drawn near the substrate surface 51 so that the protrusions 11 are at a distance D1 from the substrate surface 51 and so that the bottoms of the recesses 12 are at a distance D2 from the substrate surface 51. In the second position, the plasma generating apparatus is operated in pressure and voltage conditions so that a local plasma areas 22 ignite between the surface 51 of the substrate 5 and the recesses 12 and the protrusions 11 provide a shadowing effect preventing plasma ignition between the protrusions 11 and the surface 51 of the substrate 5, similarly as described in relation with Figure 1. Alternatively, the plasma generating apparatus with a two-part first electrode assembly can be operated in pressure and voltage conditions similar to those described in relation with Figure 2.

The patterned deposited layers may have a thickness of 5 nanometers to several hundred of nanometers, with sub-millimeter critical dimensions.

### Process

We will now describe Figures 5A-5C an example of integrated process using a plasma generating apparatus according to the first embodiment of the invention.

In Figure 5A, the plasma generating apparatus operates in the third regime, the first electrode assembly 1 being placed at a distance and the pressure P being adjusted, so that both products PxD1 and PxD2 are situated between the first threshold T1 and the second threshold T2, and the plasma 30 ignites over the whole volume between the first electrode assembly and the substrate surface 51. This step is for example used for depositing a passivation layer of intrinsic amorphous hydrogenated silicon (i-layer) or for the removal of a native oxide layer.

In Figure 5B, the plasma generating apparatus operates in the first regime, the first electrode assembly 1 being placed at a distance D1 and/or the pressure P being adjusted, so that the product PxD1 is lower than the first threshold T1 and the product PxD2 is between the first threshold T1 and the second threshold T2. For example, the first electrode assembly 1 is drawn near the substrate surface 51, so that localized plasma areas 22 ignite between the recesses 12 and surface 51 of the substrate 5, while the protrusions 11 prevent local plasma ignition between the protrusions 11 and the surface 51 of the substrate 5. This second step may be used for depositing a n-doped patterned layer 32 using the appropriate input gas mixture, such as a mixture of H₂, SiH₄, and PH₃.

In Figure 5C, the first electrode assembly 1 is rotated and/or translated by a distance X1 relatively to the sample surface 51, so as to align the recesses 12 in between the patterned layer 32 deposited at the previous step. The input gas is switched so as to deposit another patterned layer, ideally in this example a p-doped layer, from a gas mixture composed of H₂, SiH₄, and B₂H₆. For example, the movement of the first electrode assembly 1 is of about 0.5-2 mm with sub-millimeter precision. The plasma generating apparatus operates again in the first regime, the first electrode assembly 1 being placed at a distance and the pressure P being adjusted, so that the product PxD1 is lower than the first threshold T1 and the product PxD2 is between the first threshold T1 and the second threshold T2, so that localized plasma areas 23 ignite between the recesses 12 and surface 51 of the substrate 5, while the protrusions 11 prevent local plasma ignition between the protrusions 11 and the surface 51 of the substrate 5. This second step may be used for depositing a p-doped patterned layer 33. Equivalently, the rotation or translation may be implemented by the second electrode assembly or simply the substrate, whichever is most suitable for the practical implementation of the relative motion.

The steps illustrated on figures 5A-5C can be repeated with as many movable parts and steps as desired. The n-layer pattern and the p-layer pattern may or may not be identical. The process flow of figure 5 enables the deposition of the passivating layer and of patterned layers with two different doping levels. This process finds application for example to the manufacture of IBC solar cells, in a single process flow, and in a single reactor chamber, at the expense of a relative movement between the first electrode assembly 1 and the substrate surface 51.

The first electrode assembly and processing conditions enable deposition of multiple patterned and/or non-patterned layers in sequential process steps.

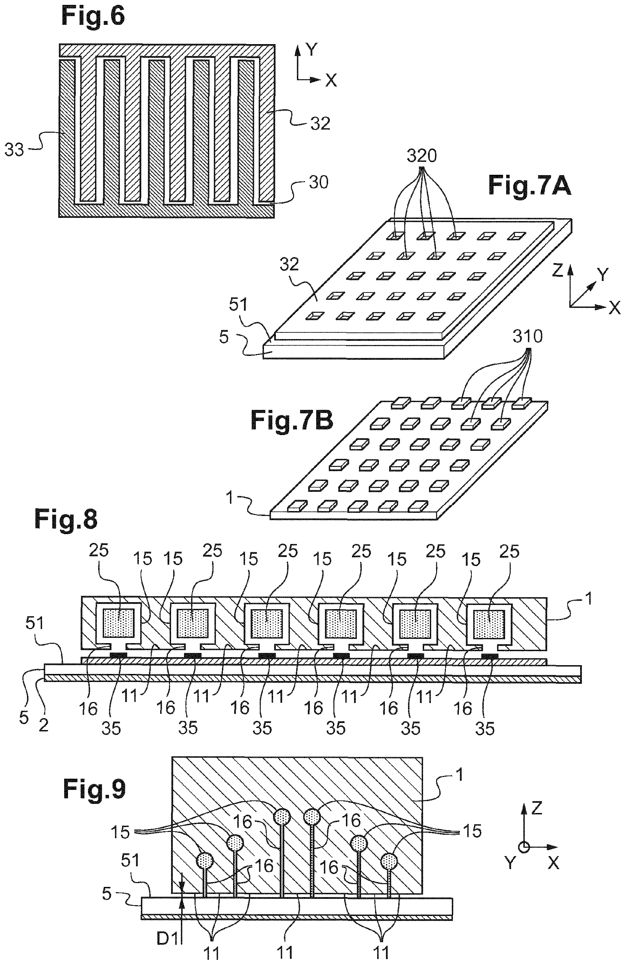

Figure 6 shows a top view of an exemplary patterned device as obtained by a process and plasma generating apparatus as described above. The patterned device comprises a uniform passivating i-layer 30, a n-doped patterned layer 32 and a p-doped patterned layer 33. The passivation layer 30 covers the whole surface of the substrate 5.

Figure 7A shows another exemplary patterned device obtained by applying spatially resolved plasma etching for forming openings 320 in a dielectric layer 32 on the surface 51 of a sample 5. This patterned structure may be realized in two steps : step 1- uniform deposition of a dielectric layer, and step 2- spatially resolved plasma etching. Optionally, these two steps are performed in a same process flow and/or in a in a single reactor chamber.

Figure 7B shows the exemplary powered electrode design comprising protrusions 310 required to achieve the pattern (displayed in Figure 7A) of openings 320 on the surface 51 of a sample 5. This patterned structure illustrated on Fig. 7A may be realized in a single step using the electrode design represented on Fig. 7B.

Figure 8 represents schematically a cross-section of a plasma processing apparatus according to a second embodiment of the invention. The first electrode assembly 1 comprises a plurality of protrusions 11, and a plurality of cavities 15, each cavity 15 being connected to the inter-electrode volume by a channel 16. The protrusions 11 are placed at a distance D1 so as to prevent local plasma ignition between the surface 51 of the substrate 5 and the protrusions 11. The cavities are dimensioned so that their volume enables ignition of local plasma areas 25 inside each cavity 15. The channel 16 generally has a smaller lateral dimension than the cavity 15. The length and width of the channel are dimensioned so as to allow diffusion of the plasma 25 between the cavity 15 and the surface 51 of the sample 5. Thus, this second embodiment enables deposition of patterned layer 35 having approximately the transverse dimensions of the channels 16.

Of course, the second embodiment can also be used for local plasma etching, for example to produce openings in a dielectric layer.

The cavities 15 may have a one-dimensional or two-dimensional configuration.

For example, the cavities 15 and channels 16 have a one-dimension geometry extending longitudinally along the Y-axis, for generating patterns extending longitudinally on the surface of the sample along the Y-axis. In another example, the cavities 15 and channels 16 have a two-dimension geometry and for example, have a similar profile as illustrated on Figure 8 along the Y axis, for generating patterns limited in both directions X and Y on the surface 51 of the sample 5. A first electrode assembly may comprise a combination of one-dimension and two-dimension cavities and channels, depending on the application.

The cavities 15 and channels 16 illustrated on Figure 8 have a square or rectangular profile.

As compared to the first embodiment, the second embodiment enables forming patterns with smaller feature size, for example patterns having critical dimensions less than twice the sheath width of the plasma.

Figure 9 represents a cross-section of different cavities 15 having a spherical (2D geometry) or cylindrical (1 D geometry) shape and channels having a cylindrical (2D geometry) or slit shape (1 D geometry).

A first electrode assembly as illustrated on Figure 9 is used for depositing a-Si:H patterned layer, in a mixture of hydrogen and silane gas (H₂/SiH₄=100:2.5), under a pressure P of 1060 mTorr (141 Pa), with a power of 50 Watts. The widths of the patterned layers obtained are around 300 micrometers.

The cavities 15 can additionally be shaped to optimize the profile of the deposited film, or the uniformity of the flux to the area being processed.

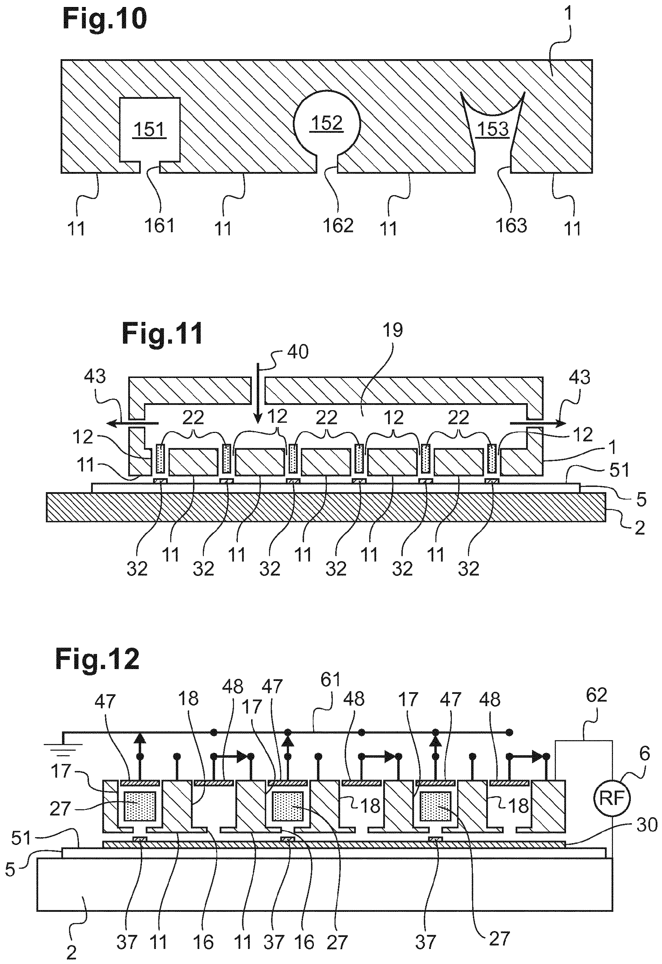

Figure 10 illustrates different cavity profiles considered to control the shape of the critical dimensions or the edges of the pattern formed. The cavity 151 has a square or rectangular profile and is connected by a channel 161 to the inter-electrode volume. The cavity 152 has a spherical or cylindrical profile and is connected by a channel 162. The cavity 153 has a conical profile and is connected by a channel 163. The conical cavity 153 may have a flat, concave or convex bottom for controlling the critical dimensions of the pattern.

Figure 11 represents a variant of the first electrode design wherein the hollows at the end of each channel 12 are fluidically connected to a common cavity 19. The cavity 19 is fluidically connected to a gas inlet 40 and to one or several gas outlets 43. This common cavity 19 enables a better distribution of input gas amongst channels 12. This configuration also enables connecting a secondary gas egress channel 43 to avoid the spreading of patterned features due to gas drag. The dimensions of the common cavity 19 and the channels 12 are chosen so that the plasma 22 ignites only nearby or within the channels 12. Optionally the channels 12 may be shaped to optimize the profile of the processed patterned areas 32 on the surface 51 of the sample.

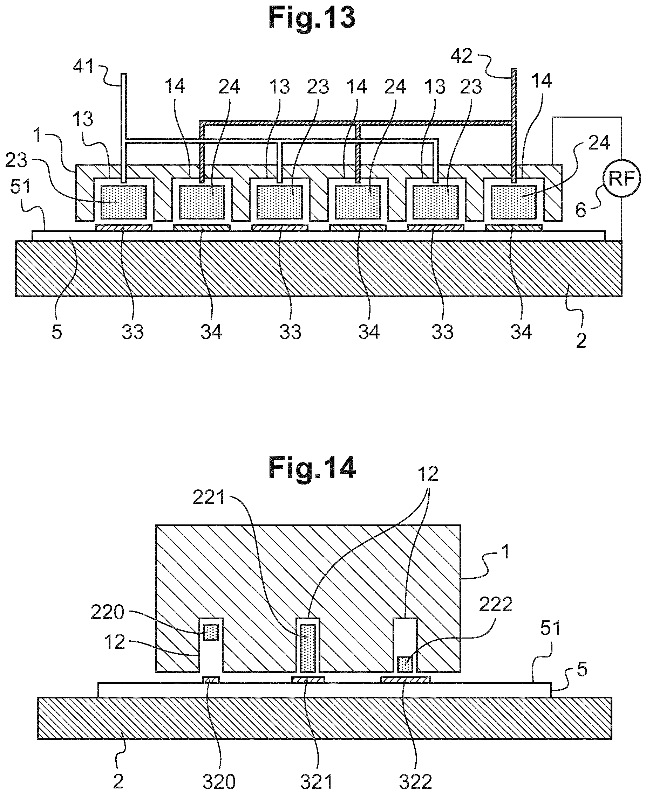

Figure 12 and 13 represent schematically variants of the electrode configuration, in cross-section.

In Figure 12, the first electrode assembly comprises a first sub-set of cavities 17 and a second sub-set of cavities 18. Each cavity 17, 18 is fluidically connected by a channel 16 to the inter-electrode volume. Each cavity 17 of the first sub-set comprises a first sub-electrode 47. Respectively, each cavity 18 of the second sub-set of cavities comprises a second sub-electrode 48. For example, in a specific operating regime illustrated Figure 11, the first sub-electrodes 47 are electrically connected to a ground line 61, while the second sub-electrodes 48 are electrically connected by a line 62 to the RF generator 6. The RF generator 6 is also electrically connected to the second electrode assembly 2. The first sub-electrodes 47 are electrically isolated from the second sub-electrodes 48. The second sub-electrodes 48 of the first electrode assembly 1 being at the same electric potential as the second electrode assembly 2, no plasma occurs in the second sub-set of cavities 18. In contrast, due to the electric potential difference between the first sub-electrodes 47 of the first electrode assembly 1 and the second electrode assembly 2, plasma ignites in the first sub-set of cavities 17. Thus, the RF generator 6 selectively powers the first sub-set of cavities 17 without powering the second sub-set of cavities 18. As an example, this configuration enables depositing patterned layers 37 on top of an i-layer 30, the patterned layers 37 being formed selectively in front of the channels 16 connected to the first sub-set of cavities 17. This configuration requires the system to be operated in a regime where plasmas do not light within the cavities 18.

The electrical connections can advantageously be modified according to the needs, so that the RF generator 6 selectively powers the second sub-set of cavities 18 without powering the first sub-set of cavities 17. Alternatively, the plasma generating apparatus of Figure 12 can be configured so that the RF generator 6 powers simultaneously the first sub-set of cavities 17 and the second sub-set of cavities 18. More generally, the plasma generating apparatus of Figure 12 can be configured so that the RF generator 6 applies a first voltage difference to the first sub-electrodes 47 and a second voltage difference to the second sub-electrodes 48, so as to control the patterns formed.

The electric configuration of the first electrode assembly as illustrated on Figure 12 can be modified in real time during a process flow.

Figure 13 shows another first electrode assembly configuration comprising a first sub-set of cavities 13 and a second sub-set of cavities 14. The gas feed assembly comprises two independent input gas lines. A first input gas line 41 injects a first input gas in the first sub-set of cavities 13. Respectively, a second input gas line 42 injects a second input gas in the second sub-set of cavities 14. The RF generator 6 is connected to first electrode assembly 1 and powers simultaneously powered by the first and second sub-set of cavities 13, 14.

The configuration of Figure 13 enables the RF generator 6 to ignite both plasma areas 23 based on the first input gas in the first sub-set of cavities 13, and simultaneously the second plasma areas 24 based on the second input gas in the second sub-set of cavities 14. This configuration enables simultaneous deposition of a first pattern 33 in front of the first sub-set of cavities 13 and a second pattern 34 in front of the second sub-set of cavities 14. For example, different doping gases 41, 42 are injected into alternating plasma zones 23, 24, enabling the simultaneous deposition of p-doped 33 and n-doped 34 patterned layers. Advantageously, the gas injection is performed through the first electrode assembly and into the volumes where plasma ignition has occurred, and the gas exit out of each subset of cavities is through an additional hole at the edge of the electrode, minimizing the gas flow through the channels. Alternatively, a quenching gas may be injected into cavities 14 to prevent ignition in these cavities 14, while allowing ignition and deposition in the other cavities 13.

The variants of the first electrode configuration described in relation with Figures 12 and 13 enable a similar process flow as described in relation with Figs 5A-5C, but without requiring any mechanical movement within the plasma reactor chamber.

Those skilled in the art will recognize that configurations combining selective electric control and selective gas injection into/for sub-sets of cavities or recesses are also contemplated without departing from the frame of the present disclosure.

A further variant on the use of the plasma generating apparatus involves the selection of the voltage difference waveform to be applied. The use of a sinusoidally varying voltage composed of a single frequency between 500kHz and 100MHz may be used. Alternatively, the simultaneous use of multiple frequencies is considered. In a particularly advantageous variant, the application of multiple harmonics of a base frequency (in the range from 500kHz to 100MHz) is considered. Depending on the respective phase between the harmonics and their respective amplitude, such waveforms can appear as a series of peaks, valleys, or as sawtooth waveforms. For example, Figure 14 shows a first electrode assembly 1 comprising a plurality of recesses 12. The recesses 12 have the same shape, dimensions and are placed at the same distance from the surface 51 of the substrate 5. Figure 14 represents schematically the position of the plasma areas 220, 221, 222 corresponding to different voltage waveforms, the other plasma parameters being identical (input gas, pressure). The use of sawtooth waveforms is of considerable interest for the electrode designs described in the present disclosure, as such waveforms allow one to control the spatial distribution of the most intense region of the plasma, as shown in figure 14. More precisely, we observe that the first plasma area 220 generated using a first sawtooth waveform voltage is located in the bottom of the recess 12 far from the sample surface, whereas the plasma area 221 generated using a second sawtooth waveform voltage is centered inside the recess 12, and the third plasma area 222 generated using a third sawtooth waveform voltage is located at the opening of the recess 12 close to the sample surface. As precursors leave the plasma, the shadowing effect of the channel walls have a varying impact on the spreading of the processed areas depending on the proximity of the plasma zone 220, respectively 221, 222 to the substrate surface. The use of such sawtooth waveforms combined with all the variants of electrode geometries, therefore, can be used to further control the profile of the deposition/etching at the surface.

The main application of the plasma generating apparatus and process disclosed herein is the formation of interdigitated back contacts or dielectric openings for the manufacture of high-efficiency crystalline silicon solar cells.

The invention allows the implementation of high-performance elements, already used in industry, with a far simpler and cheaper process. No loss in performance should be expected using the plasma lithography process and apparatus. The invention can easily be implemented on existing tools only at the expense of changing one of the electrodes of a plasma processing apparatus.

The present disclosure enables the formation of the IBC contacts in a single process step, at low temperature, and with the possibility to use a thin intrinsic a-Si:H passivation layer in the same plasma reaction chamber. The method and apparatus enable the use of both the IBC configuration combined with a HIT passivation step, without adding any additional processing step in the cell fabrication process flow. The method offers the advantage of being contactless which solves an important problems, as the surface of the clean wafer (with oxide removed) is very sensitive to damage and contamination.

Any plasma processing step that requires the activation of species by plasma can be utilized with this method. The technique, therefore, is equally useful for processes such as but not limited to deposition, etching, cleaning, densification and functionalization.

The invention finds a most suitable application in the deposition of interdigitated contacts in interdigitated back contact (IBC) and for dielectric openings in solar cells for point contacts.

The plasma lithography as disclosed herein also applies to the manufacture of other photovoltaic devices, photodetectors and sensors. The invention is defined by the claims.

## Claims

1. Plasma generating apparatus for manufacturing patterned devices comprising:
- a plasma reactor chamber;
- a gas feed assembly for introducing an input gas into the plasma reactor chamber at a chosen pressure (P);
- a first electrode assembly (1) and a second electrode assembly (2) placed in the plasma reactor chamber, the first electrode assembly (1) arranged to be spaced apart from the second electrode assembly (2) by an inter-electrode volume, and
- an electrical power supply (6) for generating a voltage difference between the first electrode assembly (1) and the second electrode assembly (2);
wherein
- the first electrode assembly (1) comprises a plurality of protrusions (11) and a plurality of recesses (12, 13, 14, 15, 16, 17,18),
- the second electrode assembly (2) is configured for receiving a substrate (5) having a surface (51) facing the plurality of protrusions (11) and the plurality of recesses (12, 13, 14, 15, 16,17,18);
**characterized in that**:
- the protrusions (11) and the recesses (12, 13, 14, 15, 16, 17, 18) are dimensioned and arranged to be set at respective distances (D1, D2) from the surface (51) of the substrate (5) so as to generate a plurality of spatially isolated plasma zones (21, 22) located selectively either between said surface of the substrate (5) and said plurality of recesses (12, 13, 14, 15, 16, 17, 18) or between said surface of the substrate (5) and said plurality of protrusions (11) at the chosen pressure (P) of the input gas.

2. Plasma generating apparatus according to claim 1 wherein the recesses (12) are dimensioned and placed at a second distance (D2) from the surface (51) of the substrate (5) such that for the applied voltage difference V(t), a product of the chosen pressure and the second distance is comprised between a first plasma ignition threshold (T1) and a second plasma extinction threshold (T2) and wherein the protrusions (11) are dimensioned and placed at a first distance (D1) from the surface (51) of the substrate (5) such that for the applied voltage difference V(t), another product of the chosen pressure (P) and the first distance (D1) is lower than the first plasma ignition threshold (T1), so that the plasma generating apparatus generates spatially isolated plasma zones (22) between the surface of the substrate (5) and the recesses (12) without generating plasma locally between the surface of the substrate (5) and the protrusions (11).

3. Plasma generating apparatus according to claim 1 wherein the protrusions (11) are dimensioned and placed at a first distance (D1) from the surface (51) of the substrate (5) such that for the applied voltage difference V(t), a product of the pressure (P) and the first distance (D1) is comprised between a first plasma ignition threshold (T1) and a second plasma extinction threshold (T2) and wherein the recesses (12) are dimensioned and placed at a second distance (D2) from the surface (51) of the substrate (5) such that for the applied voltage difference V(t), a product of the chosen pressure (P) and the second distance (D2) is larger than the second plasma extinction threshold (T2), so that the plasma generating apparatus generates spatially isolated plasma zones (21) between the surface of the substrate (5) and the protrusions (11) without generating plasma locally between the surface of the substrate (5) and the recesses (12).

4. Plasma generating apparatus according to any one of claims 1 to 3 wherein the first electrode assembly (1) comprises at least a first and a second part (111, 121), the first part (111) being mobile relatively to the second part (121) between a first position and a second position, such that, in the first position said first electrode assembly (1) forms a plurality of protrusions (11) and a plurality of recesses (12), and, in the second position, the first electrode assembly (1) forms a flat surface facing the surface of the substrate (5).

5. Plasma generating apparatus according to any one of claims 1 to 3 wherein the plurality of recesses (12, 13, 14, 15, 16, 17, 18) comprises a plurality of cavities (15, 151, 152, 153) each cavity (15, 151, 152, 153) being connected to the inter-electrode volume by a channel (16, 161, 162, 163), the cavities (15, 151, 152, 153) being dimensioned such that the apparatus generates plasma (25) within said cavities (15, 151, 152, 153) at the chosen pressure (P), and the channels (16, 161, 162, 163) being dimensioned such that the plasma (25) generated in the cavities (15, 151, 152, 153) diffuses toward the inter-electrode volume.

6. Plasma generating apparatus according to any one of claims 1 to 3 wherein the plurality of recesses (12, 13, 14, 15, 16, 17, 18) comprises a plurality of channels (12) connected to a common cavity (19), the common cavity (19) being connected to at least one gas inlet (40) and to at least one gas outlet (43).

7. Plasma generating apparatus according to claim 5 or 6 wherein said cavity (15, 19, 151, 152, 153) has a square, rectangular, spherical or conic profile and/or wherein the channels (12, 16) have a cross-section shape chosen among a rectangular, trapezoidal, conical or cylindrical shape, or a shape chosen to generate a pattern with determined spatial profile on the surface (51) of the substrate (5).

8. Plasma generating apparatus according to any one of claims 1 to 7 wherein the first electrode assembly (1) comprises at least a first and a second sub-set of recesses (17, 18), the first sub-set of recesses (17) being electrically isolated from the second sub-set of recesses (18), and the first electrode assembly (1) comprising a first and a second sub-electrodes (47, 48), the first, respectively second, sub-electrode (47, 48) electrically connecting the first, respectively second, sub-set of recesses (17, 18), and wherein the electrical power supply (6) is configured for generating a first, respectively a second, voltage difference between the first, respectively second, sub-electrodes (47, 78) and the second electrode assembly (2).

9. Plasma generating apparatus according to any one of claims 1 to 8 wherein the first electrode assembly (1) comprises at least a first and a second sub-sets of recesses (13, 14), and wherein the gas feed assembly comprises a first and a second input gas line (41, 42), the first, respectively second, gas line (41, 42) being in fluidic communication with the first, respectively second, sub-set of recesses (13, 14), so as to inject a first, respectively second, input gas into the first, respectively second, sub-set of recesses (13, 14).

10. Plasma generating apparatus according to any one of claims 1 to 9 wherein said plurality of protrusions (11) and said plurality of recesses (12, 13, 14, 15, 16, 17, 18) are arranged in a one-dimension or two-dimensional periodic array.

11. Plasma generating apparatus according to any one of claims 1 to 10 wherein said first electrode assembly (1) and/or said second electrode assembly (2) is mounted on a translation or rotating stage.

12. Plasma generating apparatus according to any one of claims 1 to 11 wherein the electrical power supply (6) is configured for generating a voltage difference to be applied between the first and second electrodes, wherein the voltage difference is constant over time, or wherein the voltage difference is time-varying and comprises a single base frequency in the range between 500kHz and 100MHz or comprises a plurality of harmonics of a base frequency in the range between 500kHz and 100MHz, and wherein the respective amplitudes and phases of the plurality of harmonics are selected so as to generate voltage difference having waveform with an amplitude asymmetry and/or with a slope asymmetry.

13. Method of manufacturing patterned devices using spatially resolved plasma processing comprising the steps of:
- Placing a substrate (5) in a plasma reactor chamber of a plasma generating apparatus, the substrate (5) being in contact with a second electrode assembly (2) and having a surface (51) facing a first electrode assembly (1) comprising a plurality of protrusions (11) and a plurality of recesses (12, 13, 14, 15, 16, 17, 18);
- Injecting an input gas or gas mixture into the plasma reactor chamber under a chosen pressure (P) ;
- configuring the first electrode assembly (1) such that the protrusions (11) are at a first distance (D1) and the recesses (12) are at a second distance (D2) from the surface (51) of the substrate (5),
- Applying a voltage difference between the first electrode assembly (1) and the second electrode assembly (2), the protrusions (11) and recesses (12, 13, 14, 15, 16, 17, 18) being dimensioned and set at respective distances (D1, D2) from the surface (51) of the substrate (5) so as to generate a plurality of spatially isolated plasma zones (21, 22) located selectively either between the surface (51) of the substrate (5) and the plurality of recesses (12) or between the surface (51) of the substrate (5) and the plurality of protrusions (11), so as to form a pattern on the surface of the substrate (5).

14. Method of manufacturing patterned devices according to claim 13 further comprising a step of:
- electrically isolating a first sub-set of recesses (17) from a second sub-set of recesses (18) of the first electrode assembly (1); and
- Applying a first, respectively, second, voltage difference between the second electrode assembly (2) and the first respectively, second, sub-set of recesses (17, 18).

15. Method of manufacturing patterned devices according to claim 13 or 14 further comprising the steps of:
- Fluidically connecting a first, respectively second, gas line (41, 42) to a first, respectively second, sub-set of recesses (13, 14) of the first electrode assembly (1); and
- Injecting a first, respectively second, input gas into the first, respectively second, sub-set of recesses (13, 14).

## Patentansprüche

1. Plasmaerzeugungsvorrichtung zur Herstellung von strukturierten Vorrichtungen mit
- einer Plasmareaktorkammer,
- einer Gaszufuhreinheit zum Zuführen eines Eingangsgases in die Plasmareaktorkammer bei einem gewählten Druck (P),
- einer in der Plasmareaktorkammer angeordneten ersten Elektrodeneinheit (1) und einer ebenda angeordneten zweiten Elektrodeneinheit (2), wobei die erste Elektrodeneinheit (1) dazu ausgelegt ist, von der zweiten Elektrodeneinheit (2) durch einen Elektrodenzwischenraum getrennt angeordnet zu sein, und
- einer elektrischen Spannungsversorgung (6) zum Erzeugen eines Spannungsunterschieds zwischen der ersten Elelctrodeneinheit (1) und der zweiten Elektrodeneinheit (2),
wobei
- die erste Elektrodeneinheit (1) eine Anzahl Erhebungen (11) und eine Anzahl Vertiefungen (12, 13, 14, 15, 16, 17, 18) aufweist und
- die zweite Elektrodeneinheit (2) dazu ausgelegt ist, ein eine der Anzahl Erhebungen (11) und der Anzahl Vertiefungen (12, 13, 14, 15, 16, 17, 18) gegenüberliegende Oberfläche (51) aufweisendes Substrat (5) aufzunehmen,
**dadurch gekennzeichnet, daß**.
- die Erhebungen (11) und die Vertiefungen (12, 13, 14, 15, 16, 17, 18) derartige Abmessungen haben und so angeordnet sind, daß sie sich bei dem gewählten Druck (P) des Eingangsgases in solchen jeweiligen Abständen (D1, D2) von der Oberfläche (51) des Substrats (5) befinden, daß sie eine Anzahl räumlich getrennter Plasmazonen (21, 22) bilden, die wahlweise entweder zwischen der Oberfläche des Substrats (5) und der Anzahl Vertiefungen (12, 13, 14, 15, 16, 17, 18) oder zwischen der Oberfläche des Substrats (5) und der Anzahl Erhebungen (11) liegen.

2. Plasmaerzeugungsvorrichtung gemäß Anspruch 1, **dadurch gekennzeichnet, daß** die Vertiefungen (12) in einem solchen zweiten Abstand (D2) von der Oberfläche (51) des Substrats (5) bemessen und angeordnet sind, daß ein Produkt aus dem gewählten Druck und dem zweiten Abstand bei der angelegten Spannungsdifferenz V(t) zwischen einer ersten Plasmazündschwelle (T1) und einer zweiten Plasmalöschschwelle (T2) liegt, und daß die Erhebungen (11) in einem solchen ersten Abstand (D1) von der Oberfläche (51) des Substrats (5) bemessen und angeordnet sind, daß ein weiteres Produkt aus dem gewählten Druck (P) und dem ersten Abstand (D1) bei der angelegten Spannungsdifferenz V(t) geringer als die erste Plasmazündschwelle (T1) ist, so daß die Plasmaerzeugungsvorrichtung räumlich getrennte Plasmazonen (22) zwischen der Oberfläche des Substrats (5) und den Vertiefungen (12) erzeugt, ohne örtlich zwischen der Oberfläche des Substrats (5) und den Erhebungen (11) Plasma zu erzeugen.

3. Plasmaerzeugungsvorrichtung gemäß Anspruch 1, **dadurch gekennzeichnet, daß** die Erhebungen (11) in einem solchen ersten Abstand (D1) von der Oberfläche (51) des Substrats (5) bemessen und angeordnet sind, daß ein Produkt aus dem gewählten Druck (P) und dem ersten Abstand (D1) bei der angelegten Spannungsdifferenz V(t) zwischen einer ersten Plasmazündschwelle (T1) und einer zweiten Plasmalöschschwelle (T2) liegt, und daß die Vertiefungen (12) in einem solchen zweiten Abstand (D2) von der Oberfläche (51) des Substrats (5) bemessen und angeordnet sind, daß ein Produkt aus dem gewählten Druck (P) und dem zweiten Abstand (D2) bei der angelegten Spannungsdifferenz V(t) größer als die zweite Plasmalöschschwelle (T2) ist, so daß die Plasmaerzeugungsvorrichtung räumlich getrennte Plasmazonen (21) zwischen der Oberfläche des Substrats (5) und den Erhebungen (11) erzeugt, ohne örtlich zwischen der Oberfläche des Substrats (5) und den Vertiefungen (12) Plasma zu erzeugen.

4. Plasmaerzeugungsvorrichtung gemäß einem der Ansprüche 1 bis 3, **dadurch gekennzeichnet, daß** die erste Elektrodeneinheit (1) wenigstens einen ersten und einen zweiten Teil (111, 121) aufweist, wobei der erste Teil (111) gegenüber dem zweiten Teil (121) zwischen einer ersten Position und einer zweiten Position bewegbar ist, so daß die Elektrodeneinheit (1) in der ersten Position eine Anzahl Erhebungen (11) und eine Anzahl Vertiefungen (12) bildet und daß die erste Elektrodeneinheit (1) in der zweiten Position eine der Oberfläche des Substrats (5) gegenüberliegende flache Oberfläche bildet.

5. Plasmaerzeugungsvorrichtung gemäß einem der Ansprüche 1 bis 3, **dadurch gekennzeichnet, daß** die Anzahl Vertiefungen (12, 13, 14, 15, 16, 17, 18) eine Anzahl Hohlräume (15, 151, 152, 153) aufweist, wobei jeder Hohlraum (15, 151, 152, 153) durch einen Kanal (16, 161, 162, 163) mit dem Elektrodenzwischenraum verbunden ist, wobei die Hohlräume (15, 151, 152, 153) so bemessen sind, daß die Vorrichtung bei dem gewählten Druck (P) in den Hohlräumen (15, 151, 152, 153) Plasma (25) erzeugt, und die Kanäle (16, 161, 162, 163) so bemessen sind, daß sich das in den Hohlräumen (15, 151, 152, 153) erzeugte Plasma (25) zum Elektrodenzwischenraum hin ausbreitet.

6. Plasmaerzeugungsvorrichtung gemäß einem der Ansprüche 1 bis 3, **dadurch gekennzeichnet, daß** die Anzahl Vertiefungen (12, 13, 14, 15, 16, 17, 18) eine Anzahl mit einem gemeinsamen Hohlraum (19) verbundene Kanäle (12) aufweist, wobei der gemeinsame Hohlraum (19) mit wenigstens einem Gaseingang (40) und wenigstens einem Gasausgang (43) verbunden ist.

7. Plasinaerzeugungsvorrichtung gemäß Anspruch 5 oder 6, **dadurch gekennzeichnet, daß** der Hohlraum (15, 19, 151, 152, 153) ein quadratisches, rechteckiges, kugelförmiges oder konisches Profil aufweist und daß die Kanäle (12, 16) eine aus einer rechteckigen, trapezförmigen, konischen oder zylindrischen Form ausgewählte Querschnittsform aufweisen oder eine solche Form aufweisen, daß an der Oberfläche (51) des Substrats (5) eine Struktur mit bestimmtem räumlichen Profil erzeugt wird.

8. Plasmaerzeugungsvorrichtung gemäß einem der Ansprüche 1 bis 7, **dadurch gekennzeichnet, daß** die erste Elektrodeneinheit (1) wenigstens eine erste und eine zweite Untergesamtheit von Vertiefungen (17, 18) aufweist, wobei die erste Untergesamtheit von Vertiefungen (17) von der zweiten Untergesamtheit von Vertiefungen (18) elektrisch getrennt ist, und wobei die erste Elektrodeneinheit (1) eine erste und eine zweite Unterelektrode (47, 48) aufweist, wobei die erste bzw. die zweite Unterelektrode (47, 48) die erste bzw. die zweite Untergesamtheit (17, 18) elektrisch verbindet, und daß die elektrische Spannungsversorgung (6) dazu ausgelegt ist, einen ersten bzw. einen zweiten Spannungsunterschied zwischen den ersten bzw. den zweiten Unterelektroden (47, 48) und der zweiten Elektrodeneinheit (2) zu erzeugen.

9. Plasmaerzeugungsvorrichtung gemäß einem der Ansprüche 1 bis 8, dadurch gekenntzeichnet, daß die erste Elektrodeneinheit (1) wenigstens eine erste und eine zweite Untergesamtheit von Vertiefungen (13, 14) aufweist und daß die Gaszufuhreinheit eine erste und eine zweite Gaszufuhrleitung (41, 42) aufweist, wobei die erste bzw. die zweite Gasleitung (41, 42) in fluidischer Verbindung mit der ersten bzw. der zweiten Untergesamtheit von Vertiefungen steht, um ein erstes bzw. ein zweites Eingangsgas in die erste bzw. in die zweite Untergesamtheit von Vertiefungen (13, 14) einzuleiten.

10. Plasmaerzeugungsvorrichtung gemäß einem der Ansprüche 1 bis 9, **dadurch gekennzeichnet, daß** die Anzahl Erhebungen (11) und die Anzahl Vertiefungen (12, 13, 14, 15, 16, 17, 18) eindimensional oder zweidimensional periodisch angeordnet sind.

11. Plasmaerzeugungsvorrichtung gemäß einem der Ansprüche 1 bis 10, **dadurch gekennzeichnet, daß** die erste Elektrodeneinheit (1) und/oder die zweite Elektrodeneinheit (2) auf einer translatorischen oder drehbaren Unterlage befestigt sind.

12. Plasmaerzeugungsvorrichtung gemäß einem der Ansprüche 1 bis 11, **dadurch gekennzeichnet, daß** die elektrische Spannungsversorgung (6) dazu ausgelegt ist, einen zwischen der ersten und der zweiten Elektrode anzulegenden Spannungsunterschied zu erzeugen, wobei der Spannungsunterschied über die Zeit konstant ist oder wobei der Spannungsunterschied zeitabhängig variiert und eine einzige Basisfrequenz im Bereich zwischen 500 kHz und 100 MHz aufweist oder eine Anzahl von Harmonischen einer Basisfrequenz im Bereich zwischen 500 kHz und 100 MHz aufweist, und daß die jeweiligen Amplituden und Phasen der Anzahl von Harmonischen so ausgewählt sind, daß ein Spannungsunterschied in Wellenform mit einer Amplitudenasymmetrie und/oder einer Flankenasymmetrie erzeugt wird.

13. Verfahren zur Herstellung von strukturierten Vorrichtungen mittels räumlich aufgelöster Plasmaverarbeitung mit den Schritten
- ein Substrat (5) in eine Plasmareaktorkammer einer Plasmaerzeugungsvorrichtung setzen, wobei das Substrat (5) mit einer zweiten Elektrodeneinheit (2) in Kontakt ist und eine Oberfläche (51) aufweist, die einer ersten Elektrodeneinheit (1) gegenüberliegt, die eine Anzahl Erhebungen (11) und eine Anzahl Vertiefungen (12, 13, 14, 15, 16, 17, 18) aufweist,
- ein Eingangsgas oder ein Gasgemisch unter einem gewählten Druck (P) in die Plasmareaktorkammer einspritzen,
- die erste Elektrodeneinheit (1) derart gestalten, daß sich die Erhebungen (11) in einem ersten Abstand (D1) und die Vertiefungen (12) in einem zweiten Abstand (D2) von der Oberfläche (51) des Substrats (5) befinden,
- einen Spannungsunterschied zwischen der ersten Elektrodeneinheit (1) und der zweiten Elektrodeneinheit (2) anlegen, wobei die Erhebungen (11) und die Vertiefungen (12, 13, 14, 15, 16, 17, 18) so bemessen und in entsprechenden Abständen (D1, D2) von der Oberfläche (51) des Substrats (5) angeordnet sind, daß sie eine Anzahl räumlich getrennter Plasmazonen (21, 22) bilden, die wahlweise entweder zwischen der Oberfläche (51) des Substrats (5) und der Anzahl Vertiefungen (12) oder zwischen der Oberfläche (51) des Substrats (5) und der Anzahl Erhebungen (11) liegen, um auf der Oberfläche des Substrats (5) eine Struktur zu bilden.

14. Verfahren zur Herstellung von strukturierten Vorrichtungen gemäß Anspruch 13, **dadurch gekennzeichnet, daß** es außerdem einen Schritt
- des elektrischen Trennens einer ersten Untergesamtheit von Vertiefungen (17) von einer zweiten Untergesamtheit von Vertiefungen (18) der ersten Elektrodeneinheit (1) und
- des Anlegens eines ersten bzw. eines zweiten Spannungsunterschieds zwischen der zweiten Elektrodeneinheit (2) und der ersten bzw. der zweiten Untergesamtheit von Vertiefungen (17, 18)
aufweist.

15. Verfahren zur Herstellung von strukturierten Vorrichtungen gemäß Anspruch 13 oder 14, **dadurch gekennzeichnet, daß** es außerdem den Schritt
- des fluidischen Verbindens einer ersten bzw. einer zweiten Gasleitung (41, 42) mit einer ersten bzw. mit einer zweiten Untergesamtheit von Vertiefungen (13, 14) der ersten Elektrodeneinheit (1) und
- des Einspritzens eines ersten bzw. eines zweiten Eingangsgases in die erste bzw. die zweite Untergesamtheit von Vertiefungen (13, 14)
aufweist.

## Revendications

1. Appareil générateur de plasma pour la fabrication de dispositifs à motifs, comprenant :
- une chambre de réacteur à plasma ;
- un ensemble d'alimentation en gaz, destiné à introduire un gaz d'entrée dans la chambre de réacteur à plasma, sous une pression choisie (P) ;
- un premier ensemble d'électrodes (1) et un deuxième ensemble d'électrodes (2) placés dans la chambre de réacteur à plasma, le premier ensemble d'électrodes (1) étant disposé de façon à être séparé du deuxième ensemble d'électrodes (2) par un volume inter-électrodes, et
- une source d'alimentation électrique (6), destinée à générer une différence de tension entre le premier ensemble d'électrodes (1) et le deuxième ensemble d'électrodes (2) ;
dans lequel
- le premier ensemble d'électrodes (1) comprend une pluralité de saillies (11) et une pluralité de renfoncements (12, 13, 14, 15, 16, 17, 18) ;
- le deuxième ensemble d'électrodes (2) est configuré pour recevoir un substrat (5) ayant une surface (51) en regard de la pluralité de saillies (11) et de la pluralité de renfoncements (12, 13, 14, 15, 16, 17, 18) ;
**caractérisé en ce que**
- les saillies (11) et les renfoncements (12, 13, 14, 15, 16, 17, 18) sont dimensionnés et disposés de façon à être situés à des distances respectives (D1, D2) de la surface (51) du substrat (5), afin de générer une pluralité de zones de plasma spatialement isolées (21, 22) situées sélectivement soit entre ladite surface du substrat (5) et ladite pluralité de renfoncements (12, 13, 14, 15, 16, 17, 18), soit entre ladite surface du substrat (5) et ladite pluralité de saillies (11) sous la pression choisie (P) du gaz d'entrée.

2. Appareil générateur de plasma selon la revendication 1, dans lequel les renfoncements (12) sont dimensionnés et placés à une deuxième distance (D2) de la surface (51) du substrat (5) de telle sorte que, pour la différence de tension appliquée V(t), un produit de la pression choisie par la deuxième distance soit compris entre un premier seuil (T1) d'allumage du plasma et un deuxième seuil (T2) d'extinction du plasma, et dans lequel les saillies (11) sont dimensionnées et placées à une première distance (D1) de la surface (51) du substrat (5) de telle sorte que, pour la différence de tension appliquée V(t), un autre produit de la pression choisie (P) par la première distance (D1) soit inférieur au premier seuil (T1) d'allumage du plasma, de telle sorte que l'appareil générateur de plasma génère des zones de plasma spatialement isolées (22) entre la surface du substrat (5) et les renfoncements (12) sans générer de plasma localement entre la surface du substrat (5) et les saillies (11).

3. Appareil générateur de plasma selon la revendication 1, dans lequel les saillies (11) sont dimensionnées et placées à une première distance (D1) de la surface (51) du substrat (5) de telle sorte que, pour la différence de tension appliquée V(t), un produit de la pression (P) par la première distance (D1) soit compris entre un premier seuil (T1) d'allumage du plasma et un deuxième seuil (T2) d'extinction du plasma, et dans lequel les renfoncements (12) sont dimensionnés et placés à une deuxième distance (D2) de la surface (51) du substrat (5) de telle sorte que, pour la différence de tension appliquée V(t), un produit de la pression choisie (P) par la deuxième distance (D2) soit plus grand que le deuxième seuil (T2) d'extinction du plasma, de telle sorte que l'appareil générateur de plasma génère des zones de plasma spatialement isolées (21) entre la surface du substrat (5) et les saillies (11) sans générer de plasma localement entre la surface du substrat (5) et les renfoncements (12).

4. Appareil générateur de plasma selon l'une quelconque des revendications 1 à 3, dans lequel le premier ensemble d'électrodes (1) comprend au moins une première et une deuxième parties (111, 121), la première partie (111) étant mobile par rapport à la deuxième partie (121) entre une première position et une deuxième position, de telle sorte que, dans la première position, ledit premier ensemble d'électrodes (1) forme une pluralité de saillies (11) et une pluralité de renfoncements (12), et, dans la deuxième position, le premier ensemble d'électrodes (1) forme une surface plane en regard de la surface du substrat (5).

5. Appareil générateur de plasma selon l'une quelconque des revendications 1 à 3, dans lequel la pluralité de renfoncements (12, 13, 14, 15, 16, 17, 18) comprend une pluralité de cavités (15, 151, 152, 153), chaque cavité (15, 151, 152, 153) étant raccordée au volume inter-électrodes par un canal (16, 161, 162, 163), les cavités (15, 151, 152, 153) étant dimensionnées de telle sorte que l'appareil génère un plasma (25) à l'intérieur desdites cavités (15, 151, 152, 153) sous la pression choisie (P), et les canaux (16, 161, 162, 163) étant dimensionnés de telle sorte que le plasma (25) généré dans les cavités (15, 151, 152, 153) diffuse vers le volume inter-électrodes.

6. Appareil générateur de plasma selon l'une quelconque des revendications 1 à 3, dans lequel la pluralité de renfoncements (12, 13, 14, 15, 16, 17, 18) comprend une pluralité de canaux (12) raccordés à une cavité commune (19), la cavité commune (19) étant raccordée à au moins une entrée de gaz (40) et à au moins une sortie de gaz (43).

7. Appareil générateur de plasma selon la revendication 5 ou 6, dans lequel ladite cavité (15, 19, 151, 152, 153) présente un profil carré, rectangulaire, sphérique ou conique, et/ou dans lequel les canaux (12, 16) présentent une forme en section transversale choisie parmi une forme rectangulaire, trapézoïdale, conique ou cylindrique, ou une forme choisie de façon à générer un motif à profil spatial prédéterminé sur la surface (51) du substrat (5).

8. Appareil générateur de plasma selon l'une quelconque des revendications 1 à 7, dans lequel le premier ensemble d'électrodes (1) comprend au moins un premier et un deuxième sous-ensembles de renfoncements (17, 18), le premier sous-ensemble de renfoncements (17) étant électriquement isolé du deuxième sous-ensemble de renfoncements (18), et le premier ensemble d'électrodes (1) comprenant une première et une deuxième sous-électrodes (47, 48), la première et la deuxième sous-électrodes (47, 48) connectant électriquement, respectivement, le premier et le deuxième sous-ensembles de renfoncements (17, 18), et dans lequel la source d'alimentation électrique (6) est configurée pour générer une première et une deuxième différences de tension entre, respectivement, la première et la deuxième sous-électrodes (47, 78) et le deuxième ensemble d'électrodes (2).

9. Appareil générateur de plasma selon l'une quelconque des revendications 1 à 8, dans lequel le premier ensemble d'électrodes (1) comprend au moins un premier et un deuxième sous-ensembles de renfoncements (13, 14), et dans lequel l'ensemble d'alimentation en gaz comprend une première et une deuxième conduites de gaz d'entrée (41, 42), la première et la deuxième conduites de gaz (41, 42) étant en communication fluidique avec, respectivement, le premier et le deuxième sous-ensembles de renfoncements (13, 14), de façon à injecter un premier et un deuxième gaz d'entrée dans, respectivement, le premier et le deuxième sous-ensembles de renfoncements (13, 14).

10. Appareil générateur de plasma selon l'une quelconque des revendications 1 à 9, dans lequel ladite pluralité de saillies (11) et ladite pluralité de renfoncements (12, 13, 14, 15, 16, 17, 18) sont disposées selon un réseau périodique monodimensionnel ou bidimensionnel.

11. Appareil générateur de plasma selon l'une quelconque des revendications 1 à 10, dans lequel ledit premier ensemble d'électrodes (1) et/ou ledit deuxième ensemble d'électrodes (2) sont montés sur une platine de translation ou de rotation.

12. Appareil générateur de plasma selon l'une quelconque des revendications 1 à 11, dans lequel la source d'alimentation électrique (6) est configurée pour générer une différence de tension destinée à être appliquée entre la première et la deuxième électrodes, la différence de tension étant constante dans le temps, ou la différence de tension variant dans le temps et comprenant une fréquence de base unique comprise dans la plage de 500 kHz à 100 MHz, ou comprenant une pluralité d'harmoniques d'une fréquence de base comprise dans la plage de 500 kHz à 100 MHz, et les amplitudes et phases respectives de la pluralité d'harmoniques étant choisies de façon à générer une différence de tension présentant une forme d'onde avec asymétrie d'amplitude et/ou avec asymétrie de pente.

13. Procédé de fabrication de dispositifs à motifs par utilisation d'un traitement plasma à résolution spatiale, comprenant les étapes suivantes :
- mise en place d'un substrat (5) dans une chambre de réacteur à plasma d'un appareil générateur de plasma, le substrat (5) étant en contact avec un deuxième ensemble d'électrodes (2) et ayant une surface (51) en regard d'un premier ensemble d'électrodes (1) comprenant une pluralité de saillies (11) et une pluralité de renfoncements (12, 13, 14, 15, 16, 17, 18) ;
- injection d'un gaz ou d'un mélange de gaz d'entrée dans la chambre de réacteur à plasma, sous une pression choisie (P) ;
- configuration du premier ensemble d'électrodes (1) de telle sorte que les saillies (11) se trouvent à une première distance (D1) et que les renfoncements (12) se trouvent à une deuxième distance (D2) de la surface (51) du substrat (5),
- application d'une différence de tension entre le premier ensemble d'électrodes (1) et le deuxième ensemble d'électrodes (2), les saillies (11) et les renfoncements (12, 13, 14, 15, 16, 17, 18) étant dimensionnés et situés à des distances respectives (D1, D2) de la surface (51) du substrat (5), de façon à générer une pluralité de zones de plasma spatialement isolées (21, 22) situées sélectivement soit entre la surface (51) du substrat (5) et la pluralité de renfoncements (12), soit entre la surface (51) du substrat (5) et la pluralité de saillies (11), de façon à former un motif sur la surface du substrat (5).

14. Procédé de fabrication de dispositifs à motifs selon la revendication 13, comprenant en outre une étape consistant à :
- isoler électriquement un premier sous-ensemble de renfoncements (17) par rapport à un deuxième sous-ensemble de renfoncements (18) du premier ensemble d'électrodes (1) ; et
- appliquer une première et une deuxième différences de tension entre le deuxième ensemble d'électrodes (2) et, respectivement, le premier et le deuxième sous-ensembles de renfoncements (17, 18).

15. Procédé de fabrication de dispositifs à motifs selon la revendication 13 ou 14, comprenant en outre les étapes suivantes :
- raccordement fluidique d'une première et d'une deuxième conduites de gaz (41, 42) à, respectivement, un premier et un deuxième sous-ensembles de renfoncements (13, 14) du premier ensemble d'électrodes (1) ; et
- injection d'un premier et d'un deuxième gaz d'entrée dans, respectivement, le premier et le deuxième sous-ensembles de renfoncements (13, 14).
